# EUROPEAN PATENT APPLICATION

(11) **EP 1 331 645 A2**
(43) Date of publication of application: **30.07.2003**
(21) Application number: 02029092.0
(22) Date of filing: 30.12.2002
(51) Int. Cl.: G11C 16/30

(54) **Method of regulating the voltages on the drain and body terminals of a nonvolatile memory cell during programming and corresponding programming circuit**

(30) Priority: 28.12.2001 EP 01830833
(71) Applicant: STMicroelectronics S.r.l., 20041 Agrate Brianza (Milano) (IT)
(72) Inventor: Micheloni, Rino, 22078 Turate (Como) (IT); Mognoni, Sabina, 20052 Monza (Miano) (IT); Motta, Ilaria, 27023 Cassolnovo (Pavia) (IT); Sacco, Andrea, 15100 Alessandria (IT)
(74) Representative: Botti, Mario

(57) **Abstract**

The invention relates to a method and a programming circuit for the regulation of voltages on the drain (D) and body (B) terminals of a non-volatile memory cell (3) while being programmed. These voltages are applied through a programming circuit (1) inserted on a conduction pattern that transfers a predetermined voltage value (VPD,Vb) on at least one terminal (D,B) of the memory cell. The method comprises a local regulation phase of said voltage value, within the programming circuit, for deleting the effect of a parasitic resistor (Rₚₐᵣ) lying on the conduction pattern.

## Description

### Field of Application

The present invention relates to a local regulating method of voltages on the drain and body terminals for a non-volatile memory cell while being programmed.

More particularly, the invention relates to a regulating method of voltages on the drain and body terminals of a non-volatile memory cell while being programmed, wherein said voltages are applied through a programming circuit inserted on a conduction path that transfers a predetermined voltage value to at least one terminal of the memory cell.

The invention also relates to a programming circuit which is incorporated to an electronic memory device integrated on a semiconductor and that comprises a non-volatile memory cell matrix, with each memory cell including at least one floating gate transistor with source, drain, gate, and body terminals, each of said programming circuits being connected with a conduction path that transfers a predetermined voltage value to a terminal of the memory cell.

### Prior Art

As is well known in this technical field, the international market pressing demand for semiconductors for high-density non-volatile memories, as for instance Flash EEPROM type, has led to the study and application of the so-called "multi-level" memory devices in which each single memory cell can store more than one bit. Each bit is associated with a predetermined logical level, and the identification of levels is possible by using memory cells with plural threshold voltages.

A skilled in the art will surely appreciate that, as the number of threshold voltage levels increases, the necessary requirements for proper performance of the operations to be carried out on the cells (erasing, programming, and reading operations) also increase.

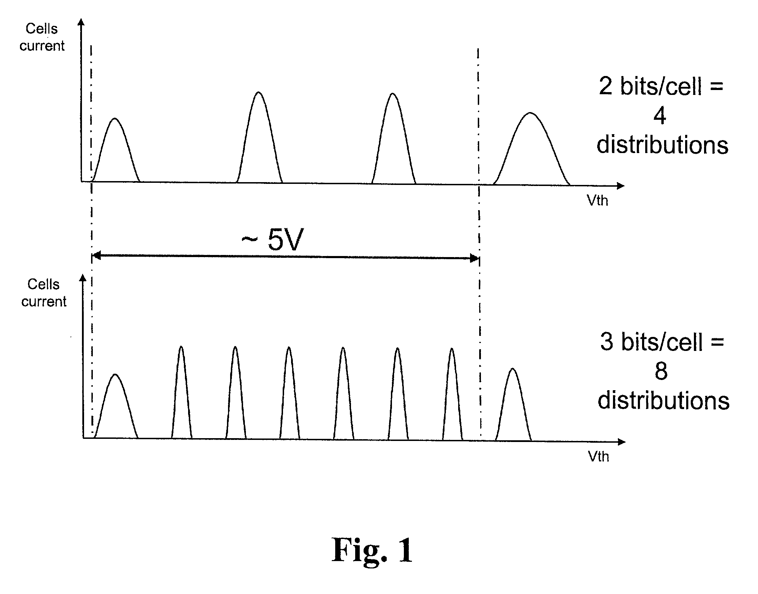

In fact, for reliability reasons, the available space to allocate the 2ⁿ-1 distributions (all of them but the most programmed one) of a multi-level non-volatile memory having n bits per cell is below 4.5 to 5 V. As a result, both the widths of threshold distributions and the gaps between them decrease. The enclosed Figure 1 shows a diagram comparing the threshold voltage distribution in a conventional two-level (two bits per cell) memory cell and in a multi-level memory having three bits per cell.

Thus, during the fabrication of multi-level memory devices, it is of great importance to consider a series of phenomena, which are instead completely negligible in conventional two-level memories.

In order to better understand the features of this invention, it is useful to examine programming steps in multi-level Flash memories, as hereby disclosed .

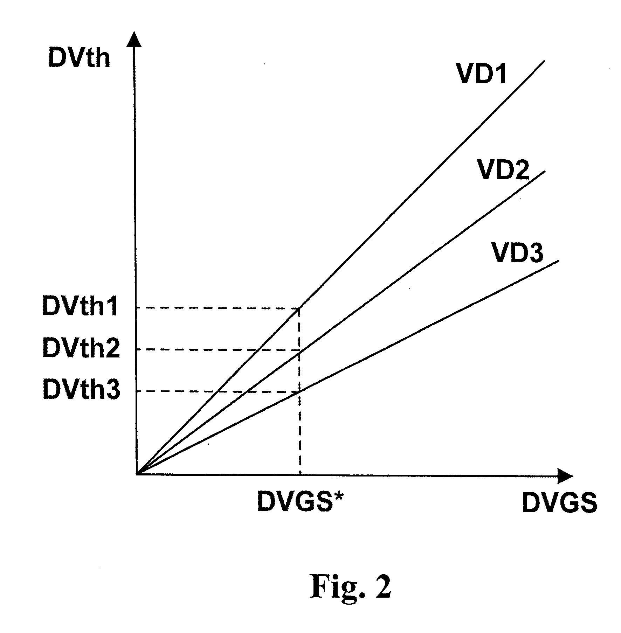

Writing in a Flash cell means varying its threshold voltage according to the desired quantity, by storing electrons in its floating gate region. Figure 2 shows some straight lines that represent the peculiar relationship existing between the voltage applied to the gate terminal of the memory cell and the threshold jump obtained through variation of the voltages applied to the drain terminal of the same cell.

In order to program the cell and obtain threshold voltage distributions that are adequately accurate for the production of the multi-level, the voltage applied to the control gate terminal can be stepwise variable, between a minimum and a maximum value. The width of the voltage step, when the drain terminal is in its best conditions, is that of the sought threshold jump.

The use of a stepwise gate voltage brings about a problem with time requirements during programming; so as to minimize programming time it is advantageous to program a large number of cells in parallel.

Programming in parallel can be performed by using a "program & verify" algorithm. As this algorithm is being executed, each programming pulse is followed by a reading phase of the cells which are being programmed, so as to check whether they have reached their threshold values or not.

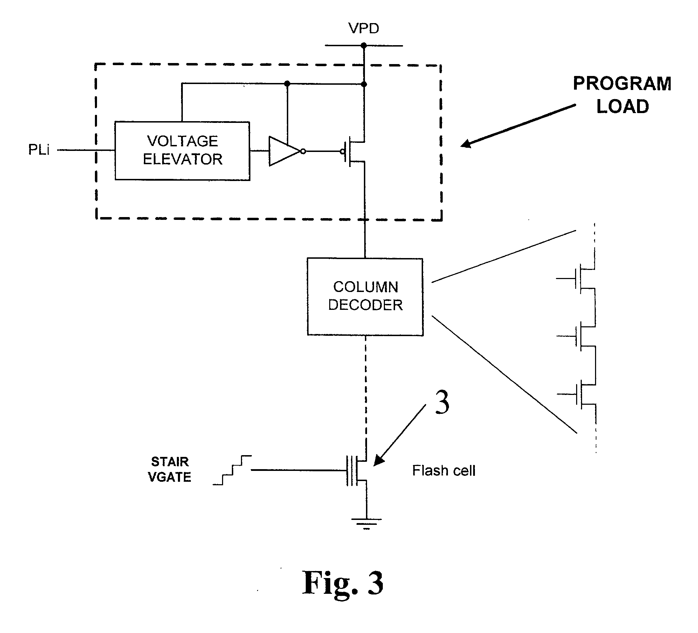

If a cell has been properly programmed, it will receive no further programming pulses, whereas those cells that are still below the desired threshold will be re-programmed by the same algorithm. For this purpose, some programming circuits are employed, by means of which it is possible to apply, in a selective way, predetermined programming voltage values on the drain terminals of the cells to be programmed. An example of these circuits, called program load, is shown schematically in Figure 3.

The number of program-load circuits is suitable to match the programming parallelism; for example, 64 program-load circuits would be provided where 64 cells are to be programmed in parallel.

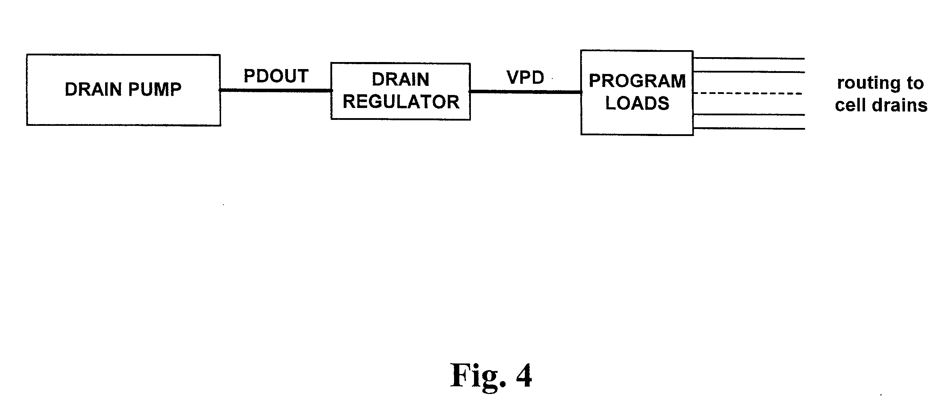

Each program-load circuit is fed by a voltage VPD which is produced by a positive voltage booster or by a charging pump DRAIN PUMP. The charging pump outputs a voltage value PDOUT, which is then regulated whithin a drain voltage regulator so that VPD supplying value is as stable and accurate as possible. Figure 4 shows schematically the sequence of functional blocks responsible for the generation of the supplying voltage VDP.

Some of the problems involved in programming Flash cells with two or more bits per cells are hereby disclosed.

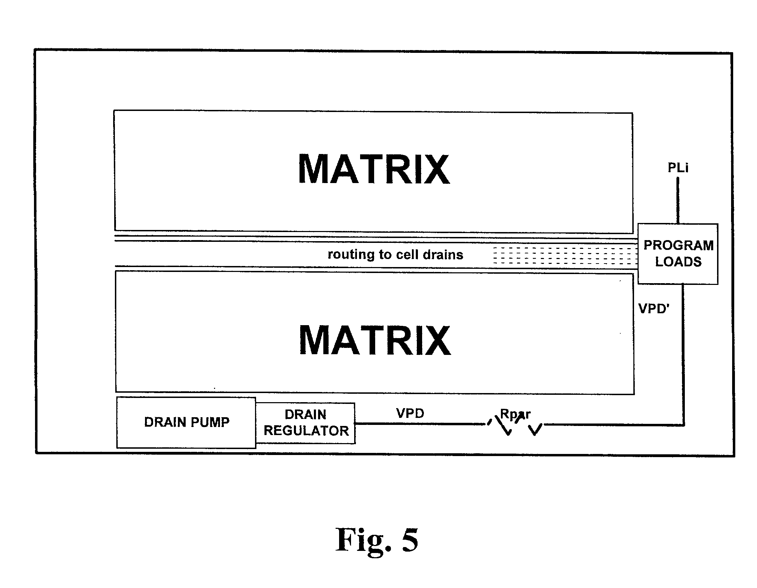

Figure 5 shows a real example of the positioning, on the layout of the memory electronic device, of circuit portions that are connected with the drain terminals of the cells, and of circuit portions suitable for the generation of the programming voltage, on the layout of an electronic memory device.

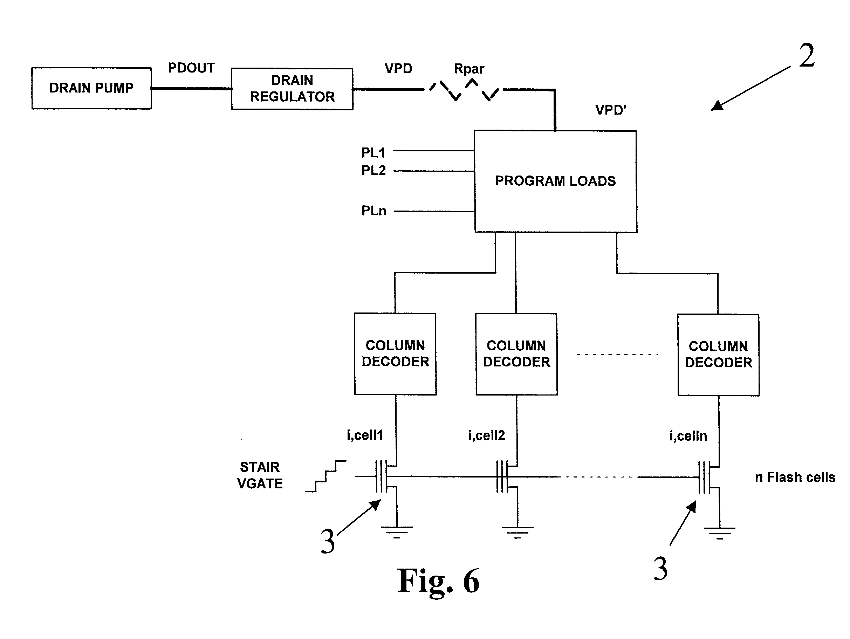

It can be appreciated from this figure that the charging pump and the regulator are fairly close to each other, and that the produced voltage VPD is led, through metallization lines, to program-load circuits located near the logical circuit portions used for driving them. The outputs of these program-load circuits are also connected, through metal routing interconnections and column decoding blocks, to the drain terminals of the cells, as Figure 6 shows in greater detail.

Program-load circuits are clustered on the electronic device layout so that the routing interconnections among their outputs and the drain terminals of the cells to be programmed can be kept as uniform as possible. This is true, however, only when the output resistance of the voltage regulator is null, which is an ideal case.

Anyway, it is common practice that the I/O logical circuit portions and high voltage circuits lay opposite in the electronic device.

On this account, the parasitic resistance value Rₚₐᵣ, introduced because of the routing interconnections coming from the supply VPD, is not to be ignored. This parasitic resistance has the effect of providing program load circuits with a voltage value VPD' , instead of voltage VPD, which is function of the current that flows through the parasitic resistor Rₚₐᵣ.

By definition, a variation in the current required by the voltage regulator does not alter its output voltage, at least not in an ideal case. The supply voltage VPD can therefore be considered a constant value as the load varies. It can thus be appreciated that the other voltage, VPD', is a configuration function of the program-load circuits and, stated otherwise, of the conduction patterns (paths) that are associated with the programming phase.

In order to solve the problem of this variation in drain voltage while programming, it is necessary to pay attention to the routing interconnections of voltage VPD,so as to minimize the parasitic resistance Rₚₐᵣ. However, this possible action is not sufficient because the metal connections toward the supply voltages VPD references cannot be expanded indefinitely, due to constraints imposed by the layout of the electronic device. Moreover, the increase in programming parallelism acts on the contrary way with respect to the solving process, because the current through the parasitic resistor Rₚₐᵣ also increases.

The underlying technical problem of this invention is that of providing a method for stabilizing voltages on the drain and body terminals of a multi-level non-volatile memory cell during the cell programming. Said method needs to have functional features that allow the drastic decrease of the effects of the parasitic resistor that appears on the interconnections between the supply voltage sources and the circuit portions arranged to be supplied therefrom.

### Summary of the Invention

The solution idea of this invention is that of regulating locally the drain voltage while programming, by multiplying the last stage of the drain regulator by the number of program-load circuits provided in the electronic device and also by shifting said stage near each one of said circuits.

According to this idea, the technical problem is solved through a method as indicated, and as defined in the herewith enclosed Claim 1.

The technical problem is also solved by a programming circuit as defined in Claim 6 and following.

The features and advantages of the method and of the circuit according to the invention will be better appreciated from the following description of an embodiment, given by way of indicative, non-limitative example with reference to the accompanying drawings.

### Brief Description of the Drawings

Figure 1 shows a diagram scheme of the threshold voltage comparing its distribution in a conventional two-level memory cell having two bits per cell and in a multi-level memory having three bits per cell.
Figure 2 shows some characteristic curves of a multi-level memory cell in a diagram of voltage vs. voltage.
Figure 3 shows a schematic view of a conventional program-load circuit.
Figure 4 shows schematically a sequence of functional blocks fit to generate a supply voltage of the drain terminal of the memory cells.
Figure 5 shows a schematic view the layout of an electronic non-volatile memory device.
Figure 6 shows a schematic view of the device shown in Figure 5, but in detail.
Figure 7 shows a schematic view of the layout of an electronic non-volatile memory device embodying this invention.
Figure 8 shows a schematic view of a programming circuit of the program-load circuit type embodying this invention.
Figure 9 shows a schematic view of a memory cell matrix section of the device of Figure 5, and associated circuitry.
Figure 10 shows a schematic view of a memory cell matrix section of the device of Figure 7, and associated circuitry according to the invention.

### Detailed Description

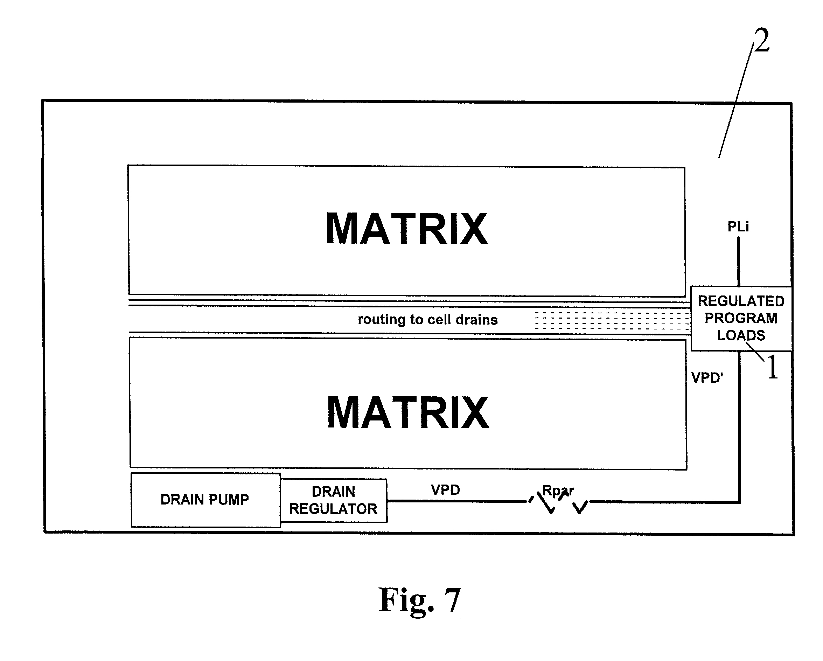

With reference to said figures, in particular to the examples of Figures 7 to 10, 1 shows, in a schematic and global way, a programming circuit of the program-load type, which is meant, according to this invention, for a memory electronic device 2 and for the local regulation of the voltage values on drain, body and source terminals of non-volatile memory cells 3 while the cells are being programmed.

A memory device is here any monolithic electronic system incorporating a memory cell matrix, being the cells arranged in rows and columns, and circuit portions associated with the cell matrix and suitable for addressing, decoding, reading, writing, and erasing of the content of the memory cells.

A device of this kind can be, for instance, a memory chip integrated on a semiconductor of the non-volatile flash-EEPROM type, divided into sections and electrically erasable.

Each memory cell comprises a floating gate transistor having source S, drain D and control gate G terminals.

Among circuit portions associated with the cell matrix, program-load circuits, as previously mentioned, are provided , each one of them being supplied with a specific supply voltage, which is generated inside the integrated memory circuit and regulated by a drain voltage regulator.

In accordance with this invention, the last stage of the drain regulator is multiplied by the number of program-load circuits 1 provided in the electronic device, said stage being shifted near each one of said programming circuits.

A new program-load circuit structure 1, internally regulated, has been invented so that the voltage applied to the drain terminal of a cell can be as stable as possible, when a voltage VPD applied to the program-load circuit is varied. In this way, the parasitic resistance Rₚₐᵣ is not suppressed, but its effect is minimized.

The advantage of this solution is that it does not introduce any complications as far as routing interconnections are considered.

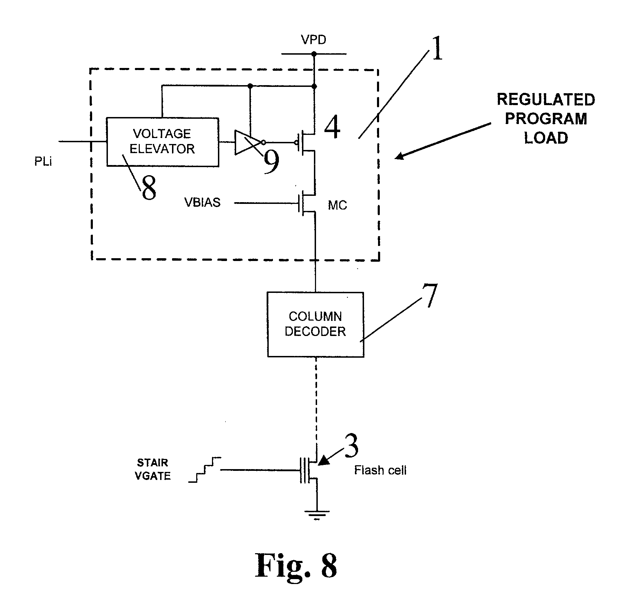

Figure 8 shows the structure of a new program-load circuit 1 which is internally regulated according to this invention. A comparison with the prior art solution, shown in Figure 3, reveals that, with respect to the conventional structure, an n-channel MC transistor has been added here, downstream of a PMOS pass transistor.

In essence, circuit 1 comprises a local voltage-regulating stage 5 to be applied to the cell terminal. This stage is connected with a conduction pattern (path) used so as to apply said voltage value on said terminal. Circuit 1 comprises a pass-transistor 4 having a first conduction terminal connected with an input of the same circuit 1, on which a voltage value VPD is applied, and it also comprises a second conduction terminal connected with an output 6 of circuit 1. Pass transistor 4 is, for example a transistor of the PMOS type.

The output 6 of circuit 1 is connected with drain terminal D of a corresponding memory cell 3 through a column decoding block 7.

The control terminal of pass transistor 4 is driven by a voltage booster 8 through an inverter 9. The voltage booster 8 picks voltage from the supply input VPD, and receives as input a enabling signal PLi.

Advantageously, stage 5 comprises transistor MC which is connected with cascode configuration between the second conduction terminal of pass transistor 4 and the output 6 of circuit 1. The gate of transistor MC is driven by a voltage VBIAS of appropriate value.

How this new configuration of program-load circuit 1 can be adapted for other modulation problems of the programming voltage of memory cells, e.g. how to regulate the body voltage of memory cells 3 locally during while programming, is herebyb disclosed.

In latest generation Flash memories, the cell substrate is not earthed while programming, but brought to negative voltage of a suitable value. This allows the creation of an electric field that prevents hot electrons from diffusing into the substrate, by consigning them within areas lying in the neighborhood of the tunnel silicon/oxide interface, thus enhancing the chances for the electrons to be entrapped in the floating gate through the positive potential that is applied to the control gate of the cell.

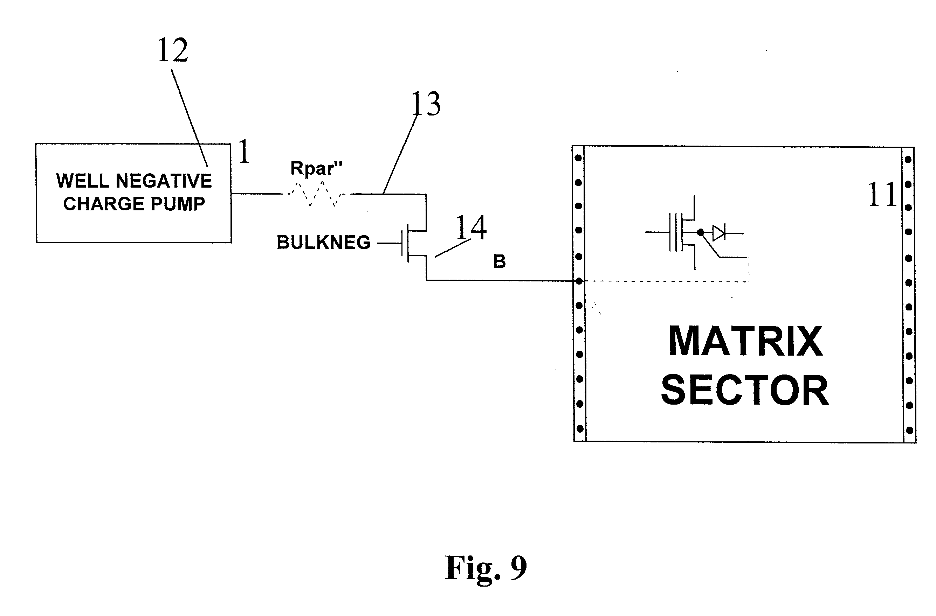

The negative voltage to be applied to the body region while programming is generated by a charge pump which is connected, at the proper time, with the substrate of the section containing the cells to be programmed. Figure 9 schematically shows a section 11 of a memory cell matrix, a negative charge pump 12, and a conduction pattern (path) 13 extending between charging pump 12 and section 11. A pass transistor 14 is connected with said pattern (path) 13 so as to apply the negative potential value to the body region of the cells 3.

Thus, while programming, the substrate of the cell 3 is a DC-consuming terminal. Metal paths of pattern 13, which carry negative voltage to pass transistors, have a a parasitic resistor Rₚₐᵣ. Likewise, if compared to what happens to the total current required by the drain charging pump, also the current required by charge pump 12 for the body region varies according to the programming pattern (path) 13 and the point reached by the algorithm. Here again, there is a modulation of the output voltage value from pass transistor 14, viz. in node B shown in Figure 9. This results in the voltage applied to the body of cell 3 that varies during the algorithm programming. In particular, since the number of connected cells at the beginning of the algorithm programming is likely to be large, the voltage droop across the parasitic resistor Rₚₐᵣ will force the voltage at node B toward less negative values, thereby originating less effective programming pulses even if cell drain stays at nominal value.

Programming pulses, applied when the number of connected cells is small, e.g. when only a few cells have to be programmed at the last distributions, will be more effective because droop across the parasitic resistor Rₚₐᵣ is smaller, and so node B will have a more negative voltage. The phenomenon thwarts the effort made in order to have regulate locally the drain voltage.

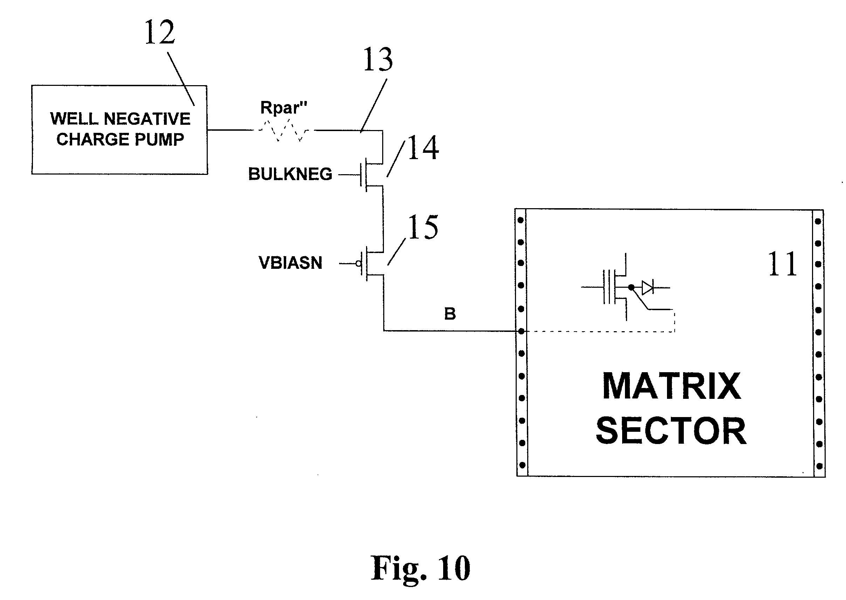

According to the invention, also the body voltage is supposed to be regulated locally, at each section, by using a structure which is a mirror image of that discussed for drain voltage regulation. Briefly, as shown in Figure 10, a transistor 15, e.g. a p-channel MOS transistor, is provided between the pass transistor 14 output and node B. Said transistor 15 is in cascode configuration with respect to transistor 14 and is polarized with a gate voltage VBIASN of suitable value. Under such conditions, cascode output, hence node B, is always constant, even if its input undergoes modulation.

To summarize, the method and the programming circuit of the invention, solve the technical problem, and allow voltages to be stabilized at the drain and body terminals of memory cells while programming multi-level Flash memories.

By maintaining stable the value of said voltages while being programmed, the above-disclosed invention allows gate pulses, applied while algorithm programming, to produce a constant threshold voltage jump for each pulse with any kind of programming pattern.

## Claims

1. Regulating method of voltages on the drain (D) and body source (S) terminals of a non-volatile memory cell (3) while being programmed, of the type in which said voltages are applied through a programming circuit (1) inserted on a conduction pattern (path) that transfers a predetermined voltage value (VPD,Vb) on at least one terminal (D,B) of the memory cell; **characterized in that** it comprises a local regulation phase of said voltage value, within said programming circuit, for deleting the effect of a parasitic resistor (Rₚₐᵣ) lying on said pattern.

2. Method, according to Claim 1, **characterized in that** said local regulation phase is carried out through a cascode connection of transistors on said conduction pattern.

3. Method, according to Claim 2, **characterized in that** local regulation phase is carried out by connecting, on said conduction pattern, a number of pass transistors that varies according to the number of cells to be programmed.

4. Programming circuit (1) incorporated in a memory electronic device (2) integrated on a semiconductor and including a non-volatile memory cell matrix (3), each cell having at least one floating gate transistor with source (S), drain (D), gate (G) and body (B) terminals, each programming circuit (1) being inserted on a conduction pattern that transfers a predetermined voltage value (VPD,Vb) on a terminal (D,B) of the memory cell, **characterized in that** it comprises a stage (5) for local regulation of said voltage for deleting the effect of a parasitic resistor (Rₚₐᵣ) lying on said pattern.

5. Circuit, according to Claim 4, wherein at least one pass transistor (4) is provided between an input receiving said voltage value (VPD) and an output (6) being connected with said drain terminal (D), **characterized in that** said regulating stage (5) comprises a transistor (MC) which is connected with cascode configuration between said pass transistor (4) and the circuit output and receiving a voltage signal (Vbias) on its own control terminal.

6. Circuit, according to Claim 4, wherein at least one pass transistor (14) is provided between a voltage booster block (12) and a section (11) of said cell matrix; **characterized in that** said regulating stage (5) comprises a transistor (15) which is connected, in cascode configuration, between said pass transistor (14) and an input node of the matrix section (11) and receiving a voltage signal (Vbiasn) on its own control terminal.

7. Multi-level electronic memory device (2) of the flash EEPROM type and monolithically integrated on a semiconductor, **characterized in that** it comprises a number of programming circuits (1) according to Claim 4, matching the programming parallelism.
